# EUROPÄISCHE PATENTANMELDUNG

(11) **EP 2 804 248 A1**
(43) Veröffentlichungstag der Anmeldung: **19.11.2014**
(21) Anmeldenummer: 13168337.7
(22) Anmeldetag: 17.05.2013
(51) Int. Cl.: H01M 10/42, G01R 31/36, H01M 10/44, H01M 10/48

(54) **Sicherstellung der Funktionsbereitschaft von Batterien**

(71) Anmelder: VEGA Grieshaber KG, 77709 Wolfach (DE)
(72) Erfinder: Allgaier, Volker, 77761 Haslach i. K. (DE); Isenmann, Andreas, 77716 Haslach i. K. (DE)
(74) Vertreter: Patentanwälte Westphal, Mussgnug & Partner

(57) **Zusammenfassung**

Die Erfindung beansprucht ein Verfahren zur Sicherstellung der Funktionsbereitschaft einer Batterie, bei welchem die Batterie zunächst mit einer Prüfvorrichtung elektrisch verbunden wird, dann mit der Prüfvorrichtung geprüft wird, ob die Batterie passiviert ist. Wenn die Batterie passiviert ist, wird ein Verfahren zur Depassivierung der Batterie durchgeführt. Ist die Batterie nicht passiviert, wird ein Zeitpunkt für die nächste Prüfung der Batterie festgelegt.

## Beschreibung

Die vorliegende Erfindung betrifft ein Verfahren zur Sicherstellung der Funktionsbereitschaft einer Batterie nach dem Oberbegriff des Patentanspruchs 1, ein Verfahren zur Prüfung der Funktionsbereitschaft einer Mehrzahl von Batterien nach dem Oberbegriff des Patentanspruchs 17, sowie eine Vorrichtung zur Durchführung eines Verfahrens zur Sicherstellung der Funktionsbereitschaft wenigstens einer Batterie. Des Weiteren betrifft die vorliegende Erfindung ein Feldgerät, mit wenigstens einer, das Feldgerät mit Energie versorgender Batterie, welches eine Vorrichtung zur Durchführung eines Verfahrens zur Sicherstellung der Funktionsbereitschaft der wenigstens einen Batterie aufweist.

Marktübliche Batterien oder chemische Primärzellen sind mittlerweile in der Lage, Feldgeräte auch unter industriellen Umgebungsbedingungen über Jahre hinweg sicher zu versorgen. Wegen der langen Lebensdauer und der teilweise sehr hohen Energiedichte sind dabei lithiumbasierte Batterien von besonderem Interesse. Im Konsumentenbereich findet am beispielsweise Lithium-Polycarbon-Monofluorid (Li/CFX) Zellen und Lithium-Mangandioxid (LiMnO₂)-Zellen, die vor allem in Kameras, Uhren und Taschenrechnern verwendet werden. Im industriellen und im medizinischen Bereich werden häufig Lithiumjodid (LiJ₂) oder Lithiumthionylchlorid (Li/SOCl₂)-Batterien verwendet.

Lithiumthionylchloridzellen haben mit einer Vorspannung zwischen 3 und 3,9 Volt die höchste Energiedichte und die höchste Vorspannung aller kommerziell erhältlichen Lithiumbatterietypen und weisen eine Lebensdauer von 15 bis 25 Jahren auf. Diese Zellen sind ideal für Anwendungen, die entweder über einen sehr langen Zeitraum einen sehr niedrigen Dauerstrom, und/oder mittlere bis hohe gepulste Ströme benötigen. Durch ihre extrem lange Lebensdauer sind sie ideal geeignet zur Anwendung in Produkten, die über eine lange Zeitdauer jederzeit einsatzbereit sein müssen.

Lithiumthionylchloridzellen gibt es in zwei Ausprägungen, die sich voneinander in ihrem mechanischen Aufbau unterscheiden. Der "Bobbin Type" hat den Lithiumanteil mit einer geringen Oberfläche integriert. Bei "Spiral Type" Zellen ist das Lithium als dünne Folie gewickelt und bietet eine deutlich größere Oberfläche. Dies führt zu zwei elektrischen Unterschieden. Zellen vom Typ "Bobbin" haben eine größere Nennkapazität aber dafür einen kleineren Nennstrom als Zellen vom Typ "Spiral". Die "Bobbin Type" Lithium Thionylchloridzellen sind speziell besonders geeignet für Niedrigstromanwendungen aufgrund ihrer hohen Energiedichte, einer sehr geringen Selbstentladungsrate und einer Lebensdauer von 15 bis 20 Jahren. "Bobbin Type" Lithium Thyonylchloridzellen können in einem Temperaturbereich zwischen - 55°C und + 125 °C Energie liefern. Eine hohe Kapazität, geringe Größe und die weitgehende Unabhängigkeit von Druckschwankungen und Temperaturschwankungen ermöglichen einen vielfältigen Einsatz dieser Zellen.

"Spiral Type" Zellen zeichnen sich dadurch aus, dass sie sehr schnell hohe Pulsströme bereitstellen können von Stromstärken bis zu mehreren Ampere für eine Zeitdauer zwischen Sekunden und 20 Minuten.

Ein Nachteil von Lithiumbatterien ist, dass sie bei längerer Lagerung eine interne, als Passivierung bezeichnete Schicht um die Anode oder Kathode aufbauen können, die bei Belastung der Batterie zu einem Spannungseinbruch führt, da dann nicht mehr genügend freie Anoden- oder Kathodenoberfläche zur Verfügung steht, um einen hinreichend großen Strom bei Nennspannung bereitstellen zu können. Lithiumthionylchloridbatterien beispielsweise bauen bei Lagerung eine interne Oxidschicht auf. Dies trifft insbesondere für die "Spiral Type" Zellen zu. Durch diesen Effekt wird die Fähigkeit der Strombelastbarkeit der Batterie minimiert.

Bei Belastung der Batterie muss diese Passivierungsschicht jedoch zunächst wieder abgebaut werden, was zu einem anfänglichen Abfall der Batteriespannung führen kann, bevor sich die Batteriespannung stabilisiert. Bei ungünstigen Lagerbedingungen (z.B. Temperaturen von über 20°C über eine längere Zeit) kann die Passivierungsschicht so stark ausgebildet sein, dass die Batterie beim Einschalten eines Feldgerätes anfänglich nicht mehr genügend Energie liefert. Dies macht sich dann dadurch bemerkbar, dass die Versorgungsspannung deutlich einbricht. Erst nach einer gewissen Belastung mit einem gewissen Mindeststrom baut sich die Passivierung in der Zelle wieder ab und die Versorgungsspannung kehrt zu ihrem ursprünglichen Wert zurück.

Das anfängliche Einbrechen der Versorgungsspannung kann daher bewirken, dass ein Feldgerät nicht mehr funktioniert, obwohl in der Batterie noch hinreichend Energie verfügbar ist.

Aufgabe der Erfindung ist es somit, ein Verfahren bereitzustellen, mit welchem eine Passivierung einer Lithiumbatterie, insbesondere einer Lithiumthionylchloridbatterie vom "Spiral Type" zuverlässig und rechtzeitig erkannt wird und ohne unnötigen Verbrauch von zu viel der in der Batterie vorhandenen Energie beseitigt werden kann, um die sofortige Funktionsbereitschaft der Batterie auch nach längeren Pausen sicherzustellen.

Diese Aufgabe wird gelöst durch ein Verfahren nach Anspruch 1. Vorteilhafte Ausführungsformen sind in den Unteransprüchen 2 bis 16 offenbart.

Sofern nicht anders beschrieben, sind die in dieser Schrift offenbarten Verfahrensschritte nacheinander auszuführen.

Um die Funktionsbereitschaft einer Batterie sicherzustellen, sieht das erfinderische Verfahren zunächst vor, dass die Batterie mit einer Prüfvorrichtung elektrisch verbunden wird, und anschließend mit der Prüfvorrichtung geprüft wird, ob die Batterie passiviert ist. Dies kann beispielsweise dadurch geschehen, dass ein Strom einer bestimmten Stromstärke für eine bestimmte Zeitdauer der Batterie entnommen wird, und dabei die an der Batterie abgreifbare Spannung beobachtet wird. Stellt sich bei dieser Prüfung heraus, dass die Batterie passiviert ist, wird ein Verfahren zur Depassivierung der Batterie durchgeführt. Eine solche Depassivierung kann beispielsweise dadurch erreicht werden, dass die Batterie für eine bestimmte Zeitdauer elektrisch belastet wird. Wenn sich herausstellt, dass die Batterie nicht passiviert ist, wird ein Zeitpunkt für die nächste Prüfung der Batterie festgelegt, und sobald dieser Zeitpunkt erreicht ist die Batterie erneut geprüft. Dies bedeutet, dass, sobald dieser Zeitpunkt erreicht ist, die Batterie entweder erneut mit der Prüfvorrichtung elektrisch verbunden wird, oder, wenn sie mit der Prüfvorrichtung noch verbunden ist, dahingehend geprüft wird, ob sie zu diesem Zeitpunkt passiviert ist oder nicht.

Ein Vorteil dieses Verfahrens ist, dass eine Depassivierung der Batterien nur dann erfolgt, wenn die Batterie vorher passiviert war. Dadurch wird ein unnötiger Abbau der in der Batterie vorhandenen Energie vermieden. Andererseits wird durch dieses Verfahren sichergestellt, dass die Batterie zu jeder Zeit, also auch nach längeren Pausen, einsatzbereit ist. Der Zeitraum zwischen zwei Batterieprüfungen kann dabei einige bis mehrere Tage, Wochen, Monate oder Jahre sein. So kann beispielsweise festgelegt werden, dass die Prüfung in wöchentlichen, monatlichen, viertel- oder halbjährlichen Abständen oder auch in jährlichen Abständen erfolgt. Andererseits kann eine Zeitdauer zwischen zwei Prüfungen auch dadurch festgelegt werden, dass die Spannung an der Batterie während der Stromentnahme gemessen wird und abhängig vom gemessenen oder ermittelten Wert der Spannung der Zeitpunkt für die nächste Prüfung der Batterie festgelegt wird.

Wenn festgestellt wurde, dass die Batterie passiviert war, und ein Verfahren zur Depassivierung der Batterie bereits durchgeführt worden ist, kann in einer bevorzugsten Ausführungsform beispielsweise erneut überprüft, bzw. festgestellt werden, ob die Batterie nun depassiviert ist, oder ob die Depassivierung der Batterie nicht erfolgreich war.

Stellt sich heraus, dass die Batterie nach der Durchführung des Verfahrens zur Depassivierung nun depassiviert ist, kann der Zustand der Batterie beispielsweise in einem elektronisch beschreibbaren Speicherelement gespeichert werden. So kann dann auch zu einem späteren Zeitpunkt noch festgestellt werden, ob ein Depassivierungsverfahren durchgeführt worden ist, welches der Batterie eine bestimmte Menge an Energie entnommen hat, oder nicht. Damit können Rückschlüsse auf die noch in der Batterie vorhandene Restkapazität gezogen werden.

Wird andererseits nach der Depassivierung der Batterie festgestellt, dass die Spannung der Batterie einen vorgegebenen Referenzwert nicht mehr erreicht, kann daraus geschlussfolgert werden, dass die Batterie unbrauchbar geworden ist. Dieser Batteriezustand kann ebenfalls festgehalten werden, beispielsweise in einem elektronisch beschreibbaren Speicherelement, so dass auch später noch festgestellt werden kann, dass die Batterie unbrauchbar geworden ist und ausgesondert werden sollte.

Wurde bei der Prüfung der Batterie mit der Prüfvorrichtung festgestellt, dass die Batterie nicht depassiviert war, kann dieser Zustand ebenfalls in dem elektronisch beschreibbaren Speicherelement gespeichert werden. Man kann dann sofort erkennen, dass keine Depassivierung durchgeführt werden musste und die Batterie daher noch keine Energie aufgrund einer De-passivierung verloren hat.

Das elektronisch beschreibbare Speicherelement benötigt für den Datenerhalt vorzugsweise keine Stromversorgung. Auf diese Weise bleibt eine in dem Speicherelement gespeicherte Information unabhängig vom Zustand der Batterie erhalten. Da für den Datenerhalt keine Stromversorgung benötigt wird, muss für den Erhalt der Information keine Batterieenergie aufgewendet werden. Das Speicherelement ist dabei vorzugsweise ein EPROM, ein EEPROM, ein FRAM oder ein RFID-Tag.

In einer bevorzugten Ausführungsform weist die Batterie selbst das elektronisch beschreibbare Speicherelement auf. Auf diese Weise kann durch einfaches Auslesen des elektronisch beschreibbaren Speicherelements der Batterie sofort festgestellt werden, ob und inwieweit die Batterie einsatzbereit ist.

Das Verfahren zur Sicherstellung der Funktionsbereitschaft einer Batterie sieht für die Prüfung der Batterie mit der Vorrichtung in einer bevorzugten Ausführungsform vor, dass folgende Verfahrensschritte durchgeführt werden:

Zunächst wird für eine erste Zeitdauer ein erster Strom der Batterie entnommen. Während der Entnahme wird eine erste Minimalspannung aus der während der ersten Zeitdauer an der Batterie abgegriffenen Spannung bestimmt. Nachdem die erste Minimalspannung bestimmt ist, wird sie mit einem vorgegebenen positiven ersten Referenzwert verglichen und es wird ein erstes Steuersignal zum Einleiten eines Verfahrens zur Depassivierung der Batterie dann bereitgestellt, wenn der Betrag der ersten Minimalspannung kleiner ist als der erste Referenzwert.

Ist der Betrag der ersten Minimalspannung größer als der erste Referenzwert, kann beispielsweise der Zustand der Batterie mit einer ersten Kennzeichnung in einem Speicherelement festgehalten werden, wobei vorzugsweise auch der Zeitpunkt für die nächste Prüfung und/oder der Zeitpunkt der ersten Kennzeichnung festgehalten wird.

Die Batterie wird vorteilhafterweise nur dann mit einer ersten Kennzeichnung versehen, wenn die Prüfung der Batterie ergeben hat, dass die Batterie in Ordnung ist, ohne dass eine Depassivierung durchgeführt werden musste. Besonders vorteilhafterweise wird eine in dem Speicherelement bereits festgehaltene erste Kennzeichnung überschrieben oder gelöscht, wenn, um die Batterie wieder einsatzbereit zu machen, eine Depassivierung durchgeführt werden muss oder musste.

Stellt sich bei der Prüfung heraus, dass die Batteriespannung zu niedrig ist und/oder dass die Batterie passiviert ist, sieht ein vorteilhaftes Verfahren zur Depassivierung der Batterie vor, dass ein zweiter Strom aus der Batterie für eine zweite Zeitdauer entnommen wird.

Vorteilhafterweise schließt an das Verfahren zur Depassivierung der Batterie eine erneute Prüfung der Batterie an, mit welcher festgestellt werden soll, ob die Batterie nach der De-passivierung einsatzbereit ist. Hierzu wird während einer dritten Zeitdauer ein dritter Strom aus der Batterie entnommen und eine zweite Minimalspannung aus der während der dritten Zeitdauer an der Batterie abgegriffenen Spannung bestimmt. Dann wird die erneut bestimmte Minimalspannung, also die zweite Minimalspannung, mit einem vorgegebenen zweiten positiven Referenzwert verglichen und, wenn der Betrag der zweiten Minimalspannung nicht kleiner ist als der zweite Referenzwert, ein zweites Steuersignal bereitgestellt.

Dabei wird vorteilhafterweise der Zustand der Batterie mit einer zweiten Kennzeichnung in einem Speicherelement festgehalten, wobei optional vorzugsweise in dem Speicherelement ein mit dem Datum der zweiten Kennzeichnung korrespondierender Zeitpunkt festgehalten wird. Weist eine Batterie eine zweite Kennzeichnung auf, geht daraus hervor, dass die Batterie bereits depassiviert wurde, damit sie wieder einsatzbereit ist.

Haben bereits mehrere Batterieprüfungen stattgefunden, kann eine möglicherweise noch vorhandene erste Kennzeichnung der Batterie überschrieben oder gelöscht werden, insbesondere dann, wenn eine Depassivierung erforderlich war.

Vorteilhafterweise wird jedes Mal, wenn die Batterie depassiviert worden ist, eine zweite Kennzeichnung im Speicherelement festgehalten, so dass aus der Anzahl der zweiten Kennzeichnungen auf die noch in der Batterie verbleibende Ladekapazität zurückgeschlossen werden kann. Da bei jeder Depassivierung der Batterie eine bestimmte Menge an Ladung entnommen wird, kann aus der Anzahl der Depassivierung ermittelt werden, wie viel Ladekapazität noch in der Batterie verbleibt.

Ergibt sich nach einer Depassivierung, dass der Betrag der erneut bestimmten Minimalspannung Uₘᵢₙ₂ kleiner ist als der vorgegebene positive zweite Referenzwert U_{ref2}, kann daraus geschlossen werden, dass die Depassivierung nicht mehr erfolgreich war. In diesem Fall kann der Zustand der Batterie mit einer dritten Kennzeichnung in dem Speicherelement festgehalten werden, wobei ein drittes Steuersignal vorteilhafterweise bereitgestellt wird, welches vorzugsweise das Kennzeichnen der Batterie mit der dritten Kennzeichnung triggert. Die Batterie sollte in einem solchen Fall ausgesondert werden, da sie unbrauchbar geworden ist.

Für die Depassivierung der Batterie kann die zweite Stromstärke größer sein als die erste Stromstärke, wobei die zweite Stromstärke vorzugsweise wenigstens zehnmal so groß ist wie I_{B1}. Um eine augenblickliche Depassivierung der Batterie zu erreichen, kann die Batterie sogar beispielsweise für einen sehr kurzen Zeitraum zwischen vorteilhafterweise 100 ms und 3 bis 5 Sekunden kurzgeschlossen werden. Die Depassivierung kann natürlich auch über einen bedeutend längeren Zeitraum erfolgen, der Depassivierungsstrom sollte dann allerdings entsprechend kleiner gewählt werden, um der Batterie nicht mehr Ladung zu entnehmen, als zur Depassivierung nötig ist.

Je nach Batteriegröße kann der Strom für die Depassivierung beispielsweise so angepasst werden, dass er zwischen 0,1 und 10 mA pro cm² Anodenfläche liegt, vorteilhafterweise etwa zwischen 0,5 und 3 mA pro cm²Anodenfläche. Wenn eine längere Depassivierungszeit von beispielsweise mehreren Minuten bis einigen Stunden akzeptabel ist, kann auch ein geringerer Entladestrom gewählt werden. So kann beispielsweise auch ein Depassivierungsstrom zwischen 5 und 50 mA für eine Zeitdauer von 5 min bis 2 Stunden zu einer Depassivierung der Batterie führen.

Um anzuzeigen, ob eine Batterie in Ordnung ist, passiviert ist oder unbrauchbar ist, kann beispielsweise ein erstes, zweites oder drittes Steuersignal ein entsprechendes akustisches und/oder optisches Signal aktivieren, mit welchen dieser Zustand angezeigt wird:

Das erste Steuersignal kann beispielsweise ein erstes akustisches und/oder ein erstes optisches Signal aktivieren, mit welchem angezeigt wird, dass die Batterie passiviert ist.

Das zweite Steuersignal kann beispielsweise ein zweites akustisches und/oder ein zweites optisches Signal aktivieren, mit welchem angezeigt wird, dass die Batterie depassiviert ist.

Das dritte Steuersignal kann ein drittes akustisches und/oder ein drittes optisches Signal aktivieren, mit dem angezeigt wird, dass die Batterie unbrauchbar ist.

Wird beispielsweise bereits bei der ersten Prüfung der Batterie festgestellt, dass die Batterie nicht passiviert ist, so kann ein viertes akustisches und/oder ein viertes optisches Signal anzeigen, dass die Batterie in Ordnung ist.

Mit dem hier beschriebenen Verfahren werden vorzugsweise Lithiumionenbatterien geprüft. Vorzugsweise ist die Lithiumionenbatterie, welche geprüft wird, eine Lithiumthionylchloridbatterie oder eine Lithiummangandioxidbatterie. Besonders vorzugsweise handelt es sich dabei um eine Lithiumionenbatterie vom "Spiral Type".

Mit dem beschriebenen Verfahren kann auch eine Mehrzahl von Batterien auf Funktionsbereitschaft überprüft werden. Hierzu wird zunächst eine Batterie ausgewählt und überprüft, ob die Batterie als unbrauchbar gekennzeichnet ist. Wenn die Batterie als unbrauchbar gekennzeichnet ist, wird sie ausgesondert. Andernfalls kann ein Verfahren zur Sicherstellung der Funktionsbereitschaft einer Batterie der bereits beschriebenen Art durchgeführt werden. Die Batterie wird, wie weiter vorne beschrieben, geprüft. Ist diese Überprüfung und die gegebenenfalls erforderliche Depassivierung der Batterie beendet, wird eine nächste Batterie ausgewählt, sofern eine nächste Batterie auswählbar ist. Konnte eine nächste Batterie ausgewählt werden, wird wieder überprüft, ob die nun ausgewählte Batterie als unbrauchbar gekennzeichnet ist. Konnte keine nächste Batterie ausgewählt werden, wird ein Zeitpunkt festgelegt, für den Start der nächsten Überprüfung der Batterien und sobald dieser Zeitpunkt erreicht ist, das Verfahren zur Prüfung der Funktionsbereitschaft einer Mehrzahl von Batterien erneut durchgeführt.

Der Zeitraum zwischen zwei Prüfungen der Funktionsbereitschaft einer Mehrzahl von Batterien beträgt dabei vorteilhafterweise zwischen 3 Monaten und ca. 5 Jahren. Der Zeitraum wird dabei besonders vorteilhafterweise abhängig von der Belastung der Batterie während eines Einsatzes in einem Gerät gewählt. Bei Batterien, die dauernd belastet sind, kann ein längerer Zeitraum gewählt werden, bei Batterien die nur selten belastet werden und nur über kurze Zeiträume, die jedoch immer betriebsbereit sein müssen, kann es notwendig werden, dass eine kürzere Zeitdauer gewählt wird.

Das beschriebene Verfahren zur Sicherstellung der Funktionsbereitschaft einer Batterie, oder das Verfahren zur Prüfung der Funktionsbereitschaft einer Mehrzahl von Batterien können daher vorzugsweise mit einer entsprechenden Vorrichtung, welche einen Anschluss zum Anschließen wenigstens einer Batterie aufweist, sowie eine mit dem Anschluss verbundene Prüfvorrichtung zur Detektion einer Pasivierung der Batterie, sowie eine mit der Prüfvorrichtung und dem Anschluss verbundene Geräteeinheit zum Depassivieren der Batterie oder der Mehrzahl von Batterien durchgeführt werden.

Besonders vorteilhaft ist es, wenn eine solche Vorrichtung in einem Feldgerät untergebracht ist, welches wenigstens eine, das Feldgerät mit Energie versorgende Batterie aufweist, wobei die wenigstens eine Batterie mit der Vorrichtung zur Durchführung des Verfahrens zur Sicherstellung der Funktionsbereitschaft einer Batterie oder einer Mehrzahl von Batterien verbunden ist, und wobei die Vorrichtung vorteilhafterweise einen Zeitgeber aufweist, mit welchen in festgelegten Zeitabständen ein solches Verfahren durchführbar ist. So kann auch in Feldgeräten, die nur selten aktiviert werden oder aktiviert werden müssen, und die mit wenigstens einer das Feldgerät mit Energie versorgenden Batterie ausgestattet sind, sichergestellt werden kann, dass das Feldgerät jederzeit einsatzbereit ist. Wenn ein Feldgerät längere Zeit nicht benutzt wird, und der das Feldgerät versorgenden Batterie, oder den das Feldgerät versorgenden Batterien deshalb über einen langen Zeitraum kein Strom entnommen wird, kann dadurch, dass im festgelegten Zeitabschnitten eine Prüfung der Batteriespannung unter Last stattfindet, und gegebenenfalls sofort eine Depassivierung eingeleitet wird, sichergestellt werden, dass die Batterie oder die Mehrzahl von Batterien immer einsatzbereit ist oder sind. Die Verwendung eines Verfahrens der beschriebenen Art in einem wenigstens eine Batterie aufweisenden Feldgerät kann daher die Funktionsbereitschaft des mit der wenigstens einen Batterie versorgten Feldgerät sicherstellen.

Die in der nachfolgenden Beschreibung verwendeten Bezeichnungen wie "oben", "unten", "links" und "rechts" und ähnliches beziehen sich auf die Ausführungsbeispiele und sollen in keiner Weise einschränkend sein, auch dann nicht, wenn sie sich auf bevorzugte Ausführungsformen beziehen.

Die Erfindung wird nachfolgend anhand von Zeichnungen näher beschrieben. Es zeigen:
- Figur 1:: ein Beispiel für einen typischen Verfahrensablauf für eine Prüfung und gegebenenfalls Depassivierung einer Batterie oder einer Mehrzahl von Batterien,
- Figur 2:: ein typisches Beispiel einer Batterieprüfung,
- Figur 3:: ein typisches Beispiel einer Batteriedepassivierung,
- Figur 4:: eine Batterieprüfvorrichtung zur Sicherstellung der Funktionsbereitschaft einer Batterie.

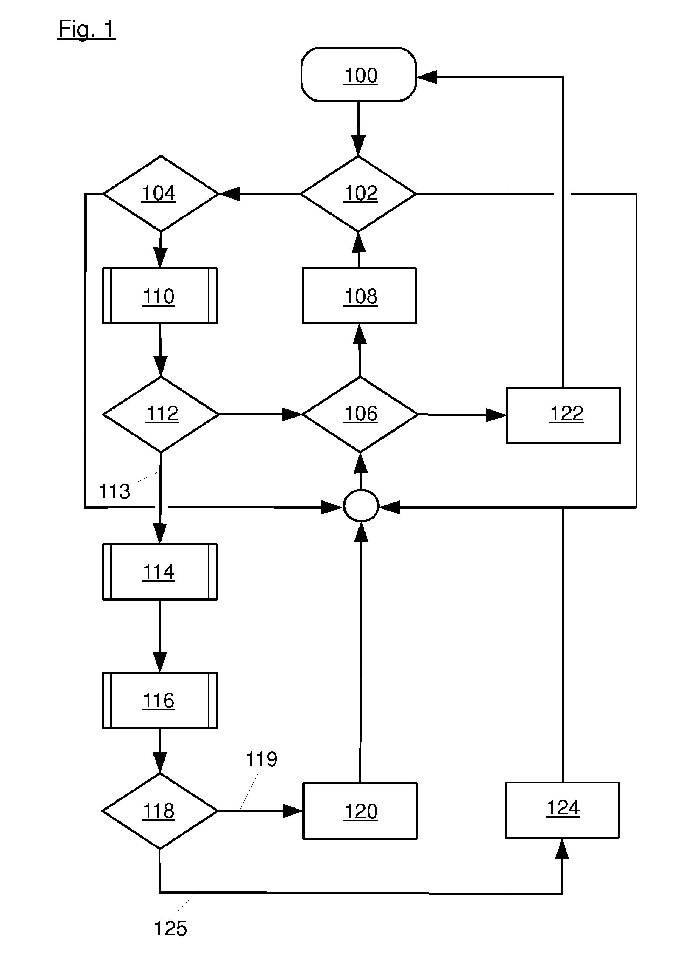

Figur 1 zeigt ein Verfahren zur Sicherstellung der Funktionsbereitschaft einer oder mehrerer Batterien. Das Verfahren wird in Startblock 100 beispielsweise damit gestartet, dass in einem ersten Komparator 102 geprüft wird, ob eine Batterie zur Verfügung steht. Wenn eine Batterie zur Verfügung steht, wird in einem zweiten Komparator 104 überprüft, ob die Batterie als unbrauchbar gekennzeichnet ist. Wenn die Batterie als unbrauchbar gekennzeichnet ist, kann sie ausgesondert werden.

Im nächsten Schritt wird dann in einem dritten Komparator 106, im Falle, dass die Batterien als unbrauchbar gekennzeichnet worden ist, geprüft, ob eine weitere Batterie zur Prüfung vorhanden ist. Ist dies der Fall, wird im Umschaltungsblock 108 auf die nächste zu prüfende Batterie umgeschaltet.

Wenn im ersten Komparator 102 festgestellt wurde, dass keine Batterie zur Prüfung vorhanden ist, wird anschließend im dritten Komparator 106 ebenfalls geprüft, ob noch eine weitere Batterie zur Prüfung vorhanden ist, die möglicherweise in einer anderen Batterieaufnahme aufgenommen ist. Ist dies der Fall, wird im Umschaltungsblock 108 auf die nächste Batterie umgeschaltet und diese dann geprüft.

Ergibt die Prüfung im zweiten Komparator 104, dass die Batterie nicht als unbrauchbar markiert worden ist, wird im Prüfungsblock 110 geprüft, ob die Batterie depassiviert ist oder nicht. Dazu wird während einer ersten Zeitdauer T_{B1} ein erster Strom I_{B1} der Batterie entnommen und währenddessen eine erste Minimalspannung Uₘᵢₙ₁ aus der während der ersten Zeitdauer T_{B1} an der Batterie abgegriffenen Spannung ermittelt.

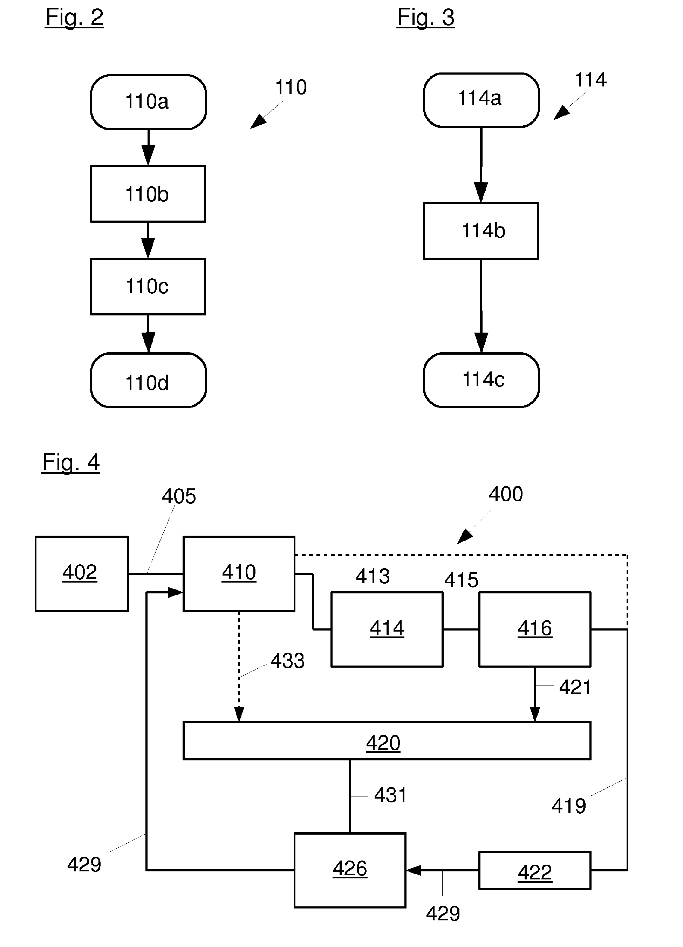

Dieser Vorgang ist in Figur 2 schematisch dargestellt: Die Batterieprüfung 110 beginnt in Startblock 110a mit der Belastung der Batterie mit einem Belastungsstrom I_{B1} während einer Zeit T_{B1} und der gleichzeitigen Spannungsüberwachung in Block 110b. Aus der während der Zeit T_{B1} abgegriffenen Spannung wird in Block 110c eine erste Minimalspannung Uₘᵢₙ₁ ermittelt, in Block 110d festgehalten und ausgelesen.

Der ausgelesene Wert Uₘᵢₙ₁ wird dann, wie wieder in Figur 1 zu sehen ist, mit einem ersten vorgegebenen Referenzwert U_{ref1} in einem vierten Komparator 112 verglichen.

Wenn der Betrag der ersten Minimalspannung Uₘᵢₙ₁ kleiner ist, als der vorgegebene positive erste Referenzwert U_{ref1}, wird ein erstes Steuersignal 113 bereitgestellt, welches das Verfahren zur Depassivierung der Batterie im Depassivierungsblock 114 einleitet.

Figur 3 zeigt schematisch den Ablauf des Depassivierungsverfahrens: Das Verfahren wird in Startblock 114a durch das erste Steuersignal 113 getriggert. Die Depassivierung der Batterie erfolgt dadurch, dass ein zweiter Strom I_{B2} aus der Batterie für eine zweite Zeitdauer T_{B2} entnommen wird in Block 114b. Wenn die zweite Zeitdauer T_{B2} beendet ist, wird das Ende der Depassivierung in Block 114c angezeigt.

Wurde im vierten Komparator festgestellt, dass der Betrag der Minimalspannung U_{ref1} nicht kleiner ist als der erste Referenzwert U_{ref1}, kann die Batterie mit einer ersten Kennzeichnung gekennzeichnet werden, aus welcher hervorgeht, dass die Batterie in Ordnung ist. In diesem Falle ist die Prüfung der Batterie beendet und es wird im dritten Komparator 106 erneut geprüft, ob eine weitere Batterie zur Prüfung zur Verfügung steht.

Wenn eine Depassivierung in Block 114 durchgeführt werden musste, kann in einem sich dem Depassivierungsblock 114 anschließenden Testblock 116 geprüft werden, ob die Passivierung erfolgreich war oder nicht. Hierzu wird ein dritter Strom I_{B3} aus der Batterie während einer dritten Zeitdauer T_{B3} entnommen, eine zweite Minimalspannung Uₘᵢₙ₂ aus der während der dritten Zeitdauer T_{B3} an der Batterie abgegriffenen Spannung bestimmt und der zweite Minimalwert Uₘᵢₙ₂ in einem fünften Komparator 118 mit einem vorgegebenen positiven zweiten Referenzwert U_{ref2} verglichen.

Stellt sich bei dieser Prüfung heraus, dass der Betrag der zweiten Minimalspannung Uₘᵢₙ₂ nicht kleiner ist als der vorgegebene zweite Referenzwert U_{ref2}, wird ein zweites Steuersignal 119 bereitgestellt. Der Zustand der Batterie kann dann mit einer zweiten Kennzeichnung in einem Datenspeicherblock 120 festgehalten werden, wobei vorzugsweise im gleichen Datenspeicherblock 120 ein mit dem Datum der zweiten Kennzeichnung korrespondierender Zeitpunkt festgehalten wird.

Eine Batterie, die eine zweite Kennzeichnung aufweist, ist eine Batterie, die nach einem Depassivierungsvorgang wieder einsatzbereit ist.

Nachdem die Daten im Speicherblock 120 gespeichert sind, ist in diesem Fall die Prüfung der Batterie beendet und im dritten Komparator 106 wird dann geprüft, ob eine weitere Batterie zur Prüfung bereitgestellt ist. Ist dies nicht der Fall, wird das Ende der gesamten Batterieprüfung im Timerblock 122 festgehalten und dem Timer eine vorher festgelegte Zeitdauer Delta t vorgegeben, nach welcher der Timer in Block 122 das nächste Prüfungsverfahren startet. Diese vorgegebene Zeitdauer kann viele Monate betragen.

Wurde im fünften Komparator 118 festgestellt, dass der Betrag der erneut bestimmten Minimalspannung Uₘᵢₙ₂ kleiner ist als der vorgegebene positive zweite Referenzwert U_{ref2}, kann der Zustand der Batterie mit einer dritten Kennzeichnung in einem Speicherblock 124 festgehalten werden, wobei die dritte Kennzeichnung der Batterie mit einem dritten Steuersignal 125 getriggert werden kann. Der Speicherblock 124 kann dabei durchaus identisch sein mit dem Block 120, er muss es jedoch nicht. Die Batterie ist in diesem Fall in Block 124 als unbrauchbar gekennzeichnet.

Im Anschluss daran kann in dem dritten Komparator 106 wieder überprüft werden, ob eine weitere Batterie zur Prüfung vorhanden ist.

Figur 4 zeigt eine Batterieprüfvorrichtung 400 mit einer Batterieaufnahme 402 zur Aufnahme einer zu prüfenden Batterie, die über eine elektrische Verbindung 405 (in Figur 4 fehlt noch das entsprechende Bezugszeichen!) mit einer Prüfvorrichtung 410 verbunden ist. Die Prüfvorrichtung 410 kann bei einer in der Batterieaufnahme 402 aufgenommenen Batterie prüfen, ob die Batterie passiviert ist oder nicht.

Dazu kann die Prüfvorrichtung 410 in einer bevorzugten Ausführungsform der Batterie einen ersten Strom I_{B1} während einer ersten Zeitdauer T_{B1} entnehmen aus der während der ersten Zeitdauer T_{B1} an der Batterie abgegriffenen Spannung eine Minimalspannung Uₘᵢₙ₁ bestimmen, und die Minimalspannung Uₘᵢₙ₁ mit einem vorgegebenen positiven ersten Referenzwert U_{ref1} vergleichen.

Ist der Betrag von Uₘᵢₙ₁ kleiner als U_{ref1} kann die Prüfvorrichtung 410 über die elektrische Verbindungsleitung 413 das erste Steuersignal 113 zum Einleiten des Verfahrens zur Depassivierung der Batterie in einer Geräteeinheit 414 bereitstellen. Die Prüfvorrichtung 410 ist dazu elektrisch über die Verbindungsleitung 413 mit der Geräteeinheit 414 verbunden, welche eine Depassivierungseinheit ist.

Wenn das erste Steuersignal 113 über die Verbindungsleitung 413 bereitgestellt ist, leitet die Geräteeinheit 414 die De-passivierung der Batterie der Batterieaufnahme 402 ein. Dazu entnimmt sie der in der Batterieaufnahme 402 aufgenommenen Batterie einen zweiten Strom I_{B2} während einer zweiten Zeitdauer T_{B2}. Dieser Vorgang depassiviert die Batterie.

Die Geräteeinheit 414 ist weiter über eine elektrische Verbindungsleitung 415 mit einer Testeinheit 416 verbunden. Nachdem die Depassivierung der Batterie in der Geräteeinheit 414 stattgefunden hat, wird in der Testeinheit 416 geprüft, ob die Batterie nun depassiviert ist oder nicht.

In einer bevorzugten Ausführungsform ist vorgesehen, dass in der Testeinheit 416 aus der in der Batterieaufnahme 402 aufgenommenen Batterie ein dritter Strom I_{B3} während einer dritten Zeitdauer t_{B3} entnommen wird, dabei erneut die Minimalspannung Uₘᵢₙ₂ auS der während der dritten Zeitdauer t_{B3} an der Batterie abgegriffenen Spannung ermittelt wird und anschließend die erneut bestimmte Minimalspannung Uₘᵢₙ₂ mit einem vorgegebenen positiven zweiten Referenzwert U_{ref2} verglichen wird.

Wenn der Betrag von Uₘᵢₙ₂ nicht kleiner ist als U_{ref2}, wird das zweite Steuersignal 119 über die Verbindungsleitung 419 bereitgestellt. Gleichzeitig wird die Information, dass die Batterie depassiviert ist, in einem Speicherelement 420 festgehalten. Hierzu ist die Testeinheit 416 mit dem Speicherelement 420 über eine elektrische Verbindungsleitung 421 verbunden.

Die Testeinheit 416 ist weiterhin mit einem Timer 422 über die Verbindungsleitung 419 verbunden. Wenn nun das Steuersignal 119 über die Verbindungsleitung 419 an den Timer geschickt wird, ist die Batterieprüfung beendet. Mit dem Ende der Batterieprüfung wird ein Zeitpunkt im Timer 422 für die nächste Batterieprüfung festgelegt. Ist dieser Zeitpunkt erreicht, triggert der Timer 422 über eine Ausleseeinheit 426 die Prüfvorrichtung 410 über die mit der Prüfvorrichtung 410 verbundene Triggerleitung 429. Die Ausleseeinheit 426 kann über eine Verbindungsleitung 431, die mit dem Speicherelement 420 verbunden ist, den in das Speicherelement 420 hineingeschriebenen Zustand der in der Batterieaufnahme 402 aufgenommenen Batterien auslesen und für die nächste Prüfung verwerten.

Wenn die Prüfung der in der Batterieaufnahme 402 aufgenommenen Batterie in der Prüfvorrichtung 410 ergibt, dass der Betrag der Minimalspannung Uₘᵢₙ₁ größer ist als der erste Referenzwert U_{ref1}, kann dieser Zustand der Batterie mit einer ersten Kennzeichnung in dem Speicherelement 420 über die Verbindungsleitung 433 festgehalten werden, wobei vorzugsweise auch der Zeitpunkt für die nächste Prüfung der Batterie und/oder der Zeitpunkt der ersten Kennzeichnung vorgegeben, und/oder festgehalten wird. In diesem Fall muss keine Depassivierung der Batterie vorgenommen werden, und die Prüfung der Batterie ist beendet. Es wird dann nur noch, wie aus der gestrichelten Linie in Figur 4 hervorgeht, für den Timer 422 ein Zeitpunkt für die nächste Prüfung dieser Batterie festgelegt und an den Timer 422 übermittelt.

In einem Versuch wurden 16 Zellen nach einer Lagerung von etwa 1 Jahr auf Passivierung geprüft. Die 16 Zellen wurden jeweils mit einem Widerstand von 5,6 Ohm belastet und ihre Spannung wurde dabei gemessen. In elf von 16 Fällen war die vom Hersteller vorgegebene Spannungsgrenze von 3 Volt unterschritten. Diese Zellen zeigten Spannungen zwischen 2,80 und 2,98 Volt. Die anderen fünf Zellen lagen leicht über der Spannungsgrenze bei Werten zwischen 3,01 und 3,04 Volt. Nach einer einstündigen Belastung der Zellen, bei der ein Strom von 35 mA den Zellen entnommen wurde, lag nur noch eine der 16 vermessenen Zellen unter der Spannungsgrenze von 3,0 Volt. Die Depassivierung der anderen 10 Zellen war somit erfolgreich.

Die Erfindung wurde anhand bevorzugter Ausführungsbeispiele erläutert ohne auf diese Ausführungsbeispiele beschränkt zu sein. Die Merkmale einzelner Ausführungsbeispiele sind frei mit Merkmalen anderer Ausführungsbeispiele kombinierbar oder austauschbar, sofern Kompatibilität vorliegt.

**Bezugszeichenliste**

| | |
|---|---|
| 100 | Startblock |
| 102 | erster Komparator |
| 104 | zweite Komparator |
| 106 | dritter Komparator |
| 108 | Umschaltungsblock |
| | |
| 110 | Prüfungsblock |
| 110a | Start Batterieprüfung |
| 110b | Belastung und Spannungsüberwachung |
| 110c | Berechnung Uₘᵢₙ₁ |
| 110d | Ende Batterieprüfung |
| 112 | vierter Komparator |
| 113 | erstes Steuersignal |
| 114 | Depassivierungsblock |
| 114a | Start Depassivierung |
| 114b | Batteriebelastung |
| 114c | Ende Depassivierung |
| 116 | Testblock |
| 118 | Fünfter Komparator |
| 119 | zweites Steuersignal |
| | |
| 120 | Datenspeicherblock |
| 122 | Timerblock |
| 124 | Speicherblock |
| 125 | drittes Steuersignal |
| | |
| 400 | Batterieprüfvorrichtung |
| 402 | Batterieaufnahme |
| 405 | Verbindung |
| 410 | Prüfvorrichtung |
| 413 | Verbindung |
| 414 | Geräteeinheit |
| 415 | Verbindung |
| 416 | Testeinheit |
| 419 | Verbindung |
| 420 | Speicherelement |
| 421 | Verbindung |
| 422 | Timer |
| 426 | Ausleseeinheit |
| 429 | Triggerleitung |
| 431 | Verbindung |
| 433 | Verbindung |

## Patentansprüche

1. Verfahren zur Sicherstellung der Funktionsbereitschaft einer Batterie,
**dadurch gekennzeichnet dass**,
a) die Batterie mit einer Prüfvorrichtung elektrisch verbunden wird,
b) mit der Prüfvorrichtung geprüft wird, ob die Batterie passiviert ist,
c1) wenn die Batterie passiviert ist, ein Verfahren zur De-Passivierung der Batterie durchgeführt wird,
c2) wenn die Batterie nicht passiviert ist, ein Zeitpunkt für die nächste Prüfung der Batterie festgelegt wird, und
d2) Schritt a oder b erneut durchgeführt wird, sobald der Zeitpunkt erreicht ist.

2. Verfahren nach Anspruch 1,
**dadurch gekennzeichnet dass**,
wenn Schritt c1 durchgeführt wurde,
d1) geprüft wird, ob die Batterie de-passiviert ist.

3. Verfahren nach Anspruch 1 oder 2,
**dadurch gekennzeichnet dass**,
der Zustand der Batterie entweder nach Schritt b oder nach Schritt d1 oder nach Schritt d2 in einem elektronisch beschreibbaren Speicherelement gespeichert wird.

4. Verfahren nach Anspruch 3,
**dadurch gekennzeichnet dass**
das Speicherelement für den Datenerhalt keine Stromversorgung benötigt, und das Speicherelement vorzugsweise ein EPROM, EEPROM, FRAM oder ein RFID-Tag ist.

5. Verfahren nach Anspruch 3 oder 4,
**dadurch gekennzeichnet dass**
die Batterie das Speicherelement aufweist.

6. Verfahren nach einem der vorigen Ansprüche,
**dadurch gekennzeichnet dass**,
Schritt b folgende Verfahrensschritte vorsieht:
- Entnehmen eines ersten Stroms I_{B1} aus der Batterie während einer ersten Zeitdauer T_{B1},
- Bestimmen einer ersten Minimalspannung Uₘᵢₙ₁ aus der während der ersten Zeitdauer T_{B1} an der Batterie abgegriffenen Spannung,
- Vergleichen der ersten Minimalspannung Uₘᵢₙ₁ mit einem vorgegebenen positiven ersten Referenzwert U_{ref1},
- Bereitstellen eines ersten Steuersignals zum Einleiten des Verfahrens zur De-Passivierung der Batterie, wenn der Betrag von Uₘᵢₙ₁ kleiner ist, als U_{ref1}.

7. Verfahren nach einem der Ansprüche 3 bis 6,
**dadurch gekennzeichnet dass**,
wenn der Betrag der ersten Minimalspannung Uₘᵢₙ₁ größer ist, als der erste Referenzwert U_{ref1}, der Zustand der Batterie mit einer ersten Kennzeichnung in dem Speicherelement festgehalten wird, wobei vorzugsweise auch der Zeitpunkt für die nächste Prüfung und/oder der Zeitpunkt der ersten Kennzeichnung festgehalten wird.

8. Verfahren nach einem der vorigen Ansprüche,
**dadurch gekennzeichnet dass**
Schritt c1 vorsieht, dass ein zweiter Strom I_{B2} aus der Batterie während einer zweiten Zeitdauer T_{B2} entnommen wird.

9. Verfahren nach einem der vorigen Ansprüche,
**dadurch gekennzeichnet dass**, Schritt d1 folgende Verfahrensschritte vorsieht:
- Entnehmen eines dritten Stroms I_{B3} aus der Batterie während einer dritten Zeitdauer T_{B3},
- Erneutes Bestimmen einer Minimalspannung Uₘᵢₙ₂ aus der während der dritten Zeitdauer an der Batterie abgegriffenen Spannung,
- Vergleichen der erneut bestimmten Minimalspannung Uₘᵢₙ₂ mit einem vorgegebenen positiven zweiten Referenzwert U-ref2, und
- Bereitstellen eines zweiten Steuersignals, wenn der Betrag von Uₘᵢₙ₂ nicht kleiner ist, als U_{ref2}.

10. Verfahren nach Anspruch 9,
**dadurch gekennzeichnet dass**,
wenn der Betrag von Uₘᵢₙ₂ nicht kleiner ist, als U_{ref2}, der Zustand der Batterie mit einer zweiten Kennzeichnung in dem Speicherelement festgehalten wird, wobei optional, vorzugsweise in dem Speicherelement, ein mit dem Datum der zweiten Kennzeichnung korrespondierender Zeitpunkt festgehalten wird.

11. Verfahren nach Anspruch 9,
**dadurch gekennzeichnet dass**
wenn der Betrag von Uₘᵢₙ₂ kleiner ist, als U_{ref2}, der Zustand der Batterie mit einer dritten Kennzeichnung in dem Speicherelement festgehalten wird, wobei ein drittes Steuersignal bereitgestellt wird, welches vorzugsweise das Kennzeichnen der Batterie mit der dritten Kennzeichnung triggert.

12. Verfahren nach einem der Ansprüche 8 bis 11,
**dadurch gekennzeichnet dass**
die zweite Stromstärke I_{B2} kleiner ist, als die erste Stromstärke I_{B1}, wobei I_{B1} vorzugsweise wenigstens zehnmal so groß ist, wie I_{B2}.

13. Verfahren nach einem der Ansprüche 6 bis 12,
**dadurch gekennzeichnet dass**
das erste Steuersignal ein erstes akustisches und/oder ein erstes optisches Signal aktiviert, mit welchem angezeigt wird, dass die Batterie passiviert ist.

14. Verfahren nach einem der Ansprüche 9 bis 13,
**dadurch gekennzeichnet dass**
das zweite Steuersignal ein zweites akustisches und/oder ein zweites optisches Signal aktiviert, mit welchem angezeigt wird, dass die Batterie de-passiviert ist.

15. Verfahren nach einem der Ansprüche 11 bis 14,
**dadurch gekennzeichnet dass** das dritte Steuersignal ein drittes akustisches und/oder ein drittes optisches Signal aktiviert, mit welchem angezeigt wird, dass die Batterie unbrauchbar ist.

16. Verfahren zur Prüfung der Funktionsbereitschaft einer Mehrzahl von Batterien, aufweisend folgende Schritte:
A) Auswählen einer Batterie,
B) Überprüfen, ob die Batterie als unbrauchbar gekennzeichnet ist,
C) Aussondern der Batterie, wenn die Batterie als unbrauchbar gekennzeichnet ist, andernfalls Durchführen eines Verfahrens nach einem der Ansprüche 1 bis 15,
D) Auswählen einer nächsten Batterie, wenn eine nächste Batterie auswählbar ist und Fortsetzen des Verfahrens mit Schritt B, andernfalls mit Schritt E,
E) Festlegen eines Zeitpunkts für den Start der nächsten Überprüfung der Batterien und Fortsetzen des Verfahrens mit Schritt A, sobald der Zeitpunkt erreicht ist.

17. Vorrichtung zur Durchführung eines Verfahrens nach einem der Ansprüche 1 bis 16, aufweisend einen Anschluss zum Anschließen wenigstens einer Batterie, eine mit dem Anschluss verbundene Prüfvorrichtung zur Detektion einer Passivierung der Batterie, sowie eine mit der Prüfvorrichtung und dem Anschluss verbundene Geräteeinheit zum De-Passivieren der Batterie.

18. Feldgerät, mit wenigstens einer, das Feldgerät mit Energie versorgenden Batterie,
**dadurch gekennzeichnet dass**
die wenigstens eine Batterie mit der Vorrichtung nach Anspruch 17 verbunden ist, wobei die Vorrichtung einen Zeitgeber aufweist, mit welchem in festgelegten Zeitabständen ein Verfahren nach einem der Ansprüche 1 bis 16 durchführbar ist.

19. Verwendung eines Verfahrens nach einem der Ansprüche 1 bis 16 in einem wenigstens eine Batterie aufweisenden Feldgerät zur Sicherstellung der Funktionsbereitschaft des mit der wenigstens einen Batterie versorgten Feldgeräts.

## Geänderte Patentansprüche

### Geänderte Patentansprüche gemäss Regel 137(2) EPÜ.

**1.** Verfahren zur Sicherstellung der Funktionsbereitschaft einer Batterie,
bei welchem
a) die Batterie mit einer Prüfvorrichtung elektrisch verbunden wird,
b) mit der Prüfvorrichtung geprüft wird, ob die Batterie passiviert ist,
c1) wenn die Batterie passiviert ist, ein Verfahren zur De-Passivierung der Batterie durchgeführt wird und,
d1) geprüft wird, ob die Batterie de-passiviert ist,
c2) wenn die Batterie nicht passiviert ist, ein Zeitpunkt für die nächste Prüfung der Batterie festgelegt wird, und d2) Schritt a oder b erneut durchgeführt wird, sobald der Zeitpunkt erreicht ist,
wobei der Zustand der Batterie entweder nach Schritt b oder nach Schritt d1 oder nach Schritt d2 in einem elektronisch beschreibbaren Speicherelement gespeichert wird, **dadurch gekennzeichnet dass** das Speicherelement für den Datenerhalt keine Stromversorgung benötigt und die Batterie das Speicherelement aufweist.

**2.** Verfahren nach Anspruch 1,
**dadurch gekennzeichnet dass** das Speicherelement ein EPROM, EEPROM, FRAM oder ein RFID-Tag ist.

**3.** Verfahren nach einem der vorigen Ansprüche,
**dadurch gekennzeichnet dass**, Schritt b folgende Verfahrensschritte vorsieht:
- Entnehmen eines ersten Stroms I_{B1} aus der Batterie während einer ersten Zeitdauer T_{B1},
- Bestimmen einer ersten Minimalspannung Uₘᵢₙ₁ aus der während der ersten Zeitdauer T_{B1} an der Batterie abgegriffenen Spannung,
- Vergleichen der ersten Minimalspannung Uₘᵢₙ₁ mit einem vorgegebenen positiven ersten Referenzwert U_{ref1},
- Bereitstellen eines ersten Steuersignals zum Einleiten des Verfahrens zur De-Passivierung der Batterie, wenn der Betrag von Uₘᵢₙ₁ kleiner ist, als U_{ref1}.

**4.** Verfahren nach einem der vorigen Ansprüche,
**dadurch gekennzeichnet dass**, wenn der Betrag der ersten Minimalspannung Uₘᵢₙ₁ größer ist, als der erste Referenzwert U_{ref1}, der Zustand der Batterie mit einer ersten Kennzeichnung in dem Speicherelement festgehalten wird, wobei vorzugsweise auch der Zeitpunkt für die nächste Prüfung und/oder der Zeitpunkt der ersten Kennzeichnung festgehalten wird.

**5.** Verfahren nach einem der vorigen Ansprüche,
**dadurch gekennzeichnet dass** Schritt c1 vorsieht, dass ein zweiter Strom I_{B2} aus der Batterie während einer zweiten Zeitdauer T_{B2} entnommen wird.

**6.** Verfahren nach einem der vorigen Ansprüche,
**dadurch gekennzeichnet dass**, Schritt d1 folgende Verfahrensschritte vorsieht:
- Entnehmen eines dritten Stroms I_{B3} aus der Batterie während einer dritten Zeitdauer T_{B3},
- Erneutes Bestimmen einer Minimalspannung Uₘᵢₙ₂ aus der während der dritten Zeitdauer an der Batterie abgegriffenen Spannung,
- Vergleichen der erneut bestimmten Minimalspannung Uₘᵢₙ₂ mit einem vorgegebenen positiven zweiten Referenzwert U-_{ref2}, und
- Bereitstellen eines zweiten Steuersignals, wenn der Betrag von Uₘᵢₙ₂ nicht kleiner ist, als U_{ref2}.

**7.** Verfahren nach Anspruch 6,
**dadurch gekennzeichnet dass**, wenn der Betrag von Uₘᵢₙ₂ nicht kleiner ist, als U_{ref2}, der Zustand der Batterie mit einer zweiten Kennzeichnung in dem Speicherelement festgehalten wird, wobei optional, vorzugsweise in dem Speicherelement, ein mit dem Datum der zweiten Kennzeichnung korrespondierender Zeitpunkt festgehalten wird.

**8.** Verfahren nach Anspruch 6,
**dadurch gekennzeichnet dass** wenn der Betrag von Uₘᵢₙ₂ kleiner ist, als U_{ref2}, der Zustand der Batterie mit einer dritten Kennzeichnung in dem Speicherelement festgehalten wird, wobei ein drittes Steuersignal bereitgestellt wird, welches vorzugsweise das Kennzeichnen der Batterie mit der dritten Kennzeichnung triggert.

**9.** Verfahren nach einem der Ansprüche 5 bis 8,
**dadurch gekennzeichnet dass** die zweite Stromstärke I_{B2} kleiner ist, als die erste Stromstärke I_{B1}, wobei I_{B1} vorzugsweise wenigstens zehnmal so groß ist, wie I_{B2}.

**10.** Verfahren nach einem der Ansprüche 3 bis 9,
**dadurch gekennzeichnet dass** das erste Steuersignal ein erstes akustisches und/oder ein erstes optisches Signal aktiviert, mit welchem angezeigt wird, dass die Batterie passiviert ist.

**11.** Verfahren nach einem der Ansprüche 6 bis 10,
**dadurch gekennzeichnet dass** das zweite Steuersignal ein zweites akustisches und/oder ein zweites optisches Signal aktiviert, mit welchem angezeigt wird, dass die Batterie de-passiviert ist.

**12.** Verfahren nach einem der Ansprüche 8 bis 11,
**dadurch gekennzeichnet dass** das dritte Steuersignal ein drittes akustisches und/oder ein drittes optisches Signal aktiviert, mit welchem angezeigt wird, dass die Batterie unbrauchbar ist.

**13.** Verfahren zur Prüfung der Funktionsbereitschaft einer Mehrzahl von Batterien, aufweisend folgende Schritte:
A) Auswählen einer Batterie,
B) Überprüfen, ob die Batterie als unbrauchbar **gekennzeichnet** ist,
C) Aussondern der Batterie, wenn die Batterie als unbrauchbar **gekennzeichnet** ist, andernfalls Durchführen eines Verfahrens nach einem der Ansprüche 1 bis 12,
D) Auswählen einer nächsten Batterie, wenn eine nächste Batterie auswählbar ist und Fortsetzen des Verfahrens mit Schritt B, andernfalls mit Schritt E,
E) Festlegen eines Zeitpunkts für den Start der nächsten Überprüfung der Batterien und Fortsetzen des Verfahrens mit Schritt A, sobald der Zeitpunkt erreicht ist.

**14.** Vorrichtung zur Durchführung eines Verfahrens nach einem der Ansprüche 1 bis 13, aufweisend einen Anschluss zum Anschließen wenigstens einer Batterie, eine mit dem Anschluss verbundene Prüfvorrichtung zur Detektion einer Passivierung der Batterie, sowie eine mit der Prüfvorrichtung und dem Anschluss verbundene Geräteeinheit zum De-Passivieren der Batterie.

**15.** Feldgerät, mit wenigstens einer, das Feldgerät mit Energie versorgenden Batterie,
**dadurch gekennzeichnet dass** die wenigstens eine Batterie mit der Vorrichtung nach Anspruch 14 verbunden ist, wobei die Vorrichtung einen Zeitgeber aufweist, mit welchem in festgelegten Zeitabständen ein Verfahren nach einem der Ansprüche 1 bis 13 durchführbar ist.

**16.** Verwendung eines Verfahrens nach einem der Ansprüche 1 bis 13 in einem wenigstens eine Batterie aufweisenden Feldgerät zur Sicherstellung der Funktionsbereitschaft des mit der wenigstens einen Batterie versorgten Feldgeräts.
